# EUROPEAN PATENT APPLICATION

(11) **EP 1 733 803 A1**
(43) Date of publication of application: **20.12.2006**
(21) Application number: 05728867.2
(22) Date of filing: 04.04.2005
(51) Int. Cl.: B05D 3/00, B05C 5/00, H01L 21/56

(54) **VISCOUS FLUID APPLICATION DEVICE**

(30) Priority: 09.04.2004 JP 2004115093; 07.05.2004 JP 2004138768; 09.07.2004 JP 2004203036; 29.07.2004 JP 2004222550
(71) Applicant: MATSUSHITA ELECTRIC INDUSTRIAL CO., LTD., Kadoma-shi, Osaka Osaka 571-0051 (JP)
(72) Inventor: NAKATSUJI, Hachiroh, Matsushita Electric Ind. Co., Chuo-ku, Osaka-shi, Osaka 540-6319 (JP); ICHIKAWA, Iwao, Matsushita Electric Ind. Co., Ltd., Chuo-ku, Osaka-shi, Osaka 540-6319 (JP); KABESHITA, Akira, Matsushita Electric Ind. Co, Ltd, Chuo-ku, Osaka-shi, Osaka 540-6319 (JP); OKAMOTO, Kenji, Matsushita Electric Indus. Co, Ltd, Chuo-ku, Osaka-shi, Osaka 540-6319 (JP); IIZUKA, Akira, Matsushita Electric Indust. Co, Ltd, Chuo-ku, Osaka-shi, Osaka 540-6319 (JP)
(74) Representative: Pautex Schneider, Nicole Véronique
(86) International application number: PCT/JP2005/006619
(87) International publication number: WO 2005/097359

(57) **Abstract**

The present invention aims to provide a viscous fluid application device which allows improving manufacturing efficiency of semiconductor packages without deteriorating application position accuracy and decreasing designing flexibility. The device includes: an application unit (101) which applies viscous fluid to a substrate 140a; an application head (100) having a supply unit (102) which supplies the viscous fluid to the application unit (101); an X axis unit (110); a Y axis unit (120); a Z axis unit (130); a substrate carrying unit (140); a head height detection sensor (150); and a control unit (160). The supply unit (102) moves in the Y direction in cooperation with a movement in the Y direction of the application unit (101), and remains unmoved irrespective of a movement in the X and Z direction of the application unit (101).

## Description

### Technical Field

The present invention relates to viscous fluid application devices, and in particular to a viscous fluid application device used in a semiconductor package manufacturing process.

### Background Art

In a high-speed semiconductor device, a flip chip technique is used for electrical connection between a semiconductor chip and an electric circuit formed on a substrate in which the semiconductor chip is mounted. Such semiconductor chip includes a diode, a transistor, an Integrated Circuit (IC) and a Large Scale integrated Circuit (LSI). As for the structures of semiconductor packages formed using the flip chip technique, there are two types of semiconductor packages which are the semiconductor package with a cover and the semiconductor package without a cover. The semiconductor package with a cover is applicable to a semiconductor package including a semiconductor chip for high frequency which generates a large amount of heat, and the semiconductor package without a cover is applicable to a semiconductor package including a semiconductor chip for low frequency which generates a comparatively small amount of heat.

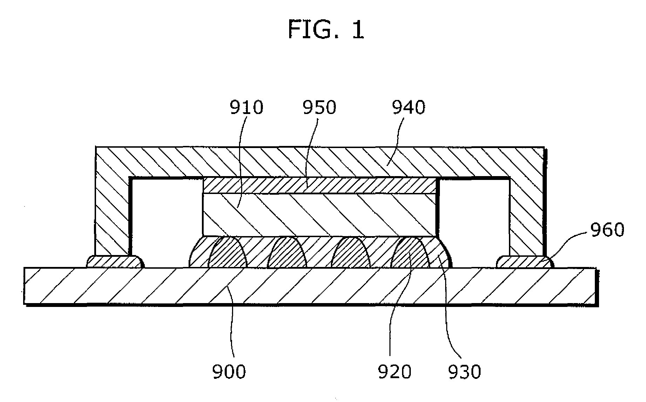

FIG. 1 is a cross-sectional view showing the structure of a semiconductor package.
The semiconductor package has a cover. The semiconductor package is configured with: a substrate 900; a semiconductor chip 910 placed on the substrate 900 so that the circuit surface faces the substrate 900; an electrode bump 920 which electrically connects the substrate 900 and the semiconductor chip 910; an underfill adhesive 930 filled between the substrate 900 and the semiconductor chip 910; a cover 940 placed on the substrate 900 so as to cover the semiconductor chip 910; a flux 950 which releases heat generated in the semiconductor chip 910 to the cover 940; and a sealing compound 900 such as silicon resin and epoxy resin which bonds the substrate 900 and the cover 940.

In manufacturing such semiconductor package having the above-described structure, viscous fluid such as an underfill adhesive, a flux and a sealing compound are applied to a substrate and a semiconductor chip by using a common viscous fluid application device (for example, refer to Patent Reference 1) which has been widely used to manufacture semiconductor packages.

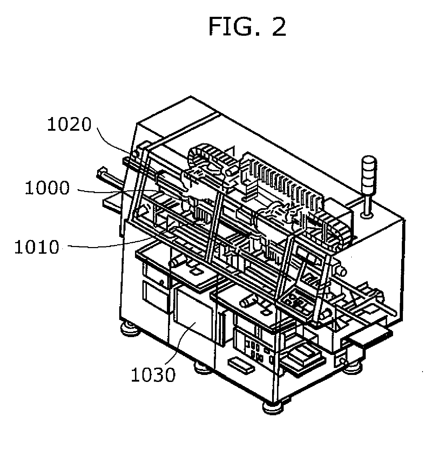

FIG. 2 is an external view of a conventional viscous fluid application device.
The viscous fluid application device includes: an application head 1000 which applies viscous fluid to a substrate; a Y table 1010 on which the substrate is placed and which performs positioning of the substrate in the Y direction; an X axis unit 1020 which performs positioning of the application head 1000 in the X direction which is orthogonal to the Y direction; and a control unit 1030 which controls actions of the Y table 1010 and the X axis unit 1020.

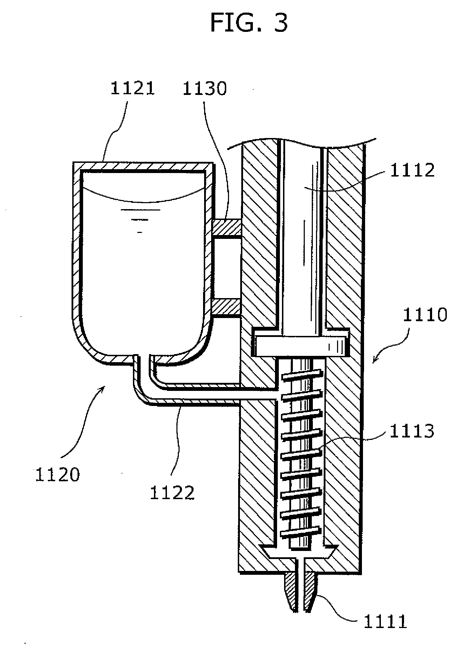

FIG. 3 is a cross-sectional view showing the structure of the application head 1000.
The application head 1000 includes an application unit 1110, a supply unit 1120 and a connection unit 1130. The application unit 1110 has a nozzle 1111 and a discharge shaft 1112 both of which are intended for discharging viscous fluid, and is movable in the X, Y and Z directions so as to apply the viscous fluid to the substrate. The supply unit 1120 has a cartridge 1121 for storing the viscous fluid and a supply pipe 1122 for leading the viscous fluid in the cartridge 1121 to the application unit 1110, and supplies the viscous fluid to the application unit 1110. The connection unit 1130 integrates the application unit 1110 and the supply unit 1120.

Here, the discharge shaft 1112 is arranged inside the application unit 1110 along the axis direction of the nozzle 1111, and is rotatable about the axis. The discharge shaft 1112 has an end in which a screw unit 1113 is formed. The screw unit 1113 causes the nozzle 1111 to discharge the viscous fluid according to a rotation of the discharge shaft 1112.

In the driving method of a viscous fluid application device having the above-described structure, in general, the action of applying viscous fluid is started by supplying compressed air into the cartridge so as to squeeze out the viscous fluid in the cartridge at the same time when the discharge shaft starts to rotate, and the action is completed by stopping the supply of the compressed air into the cartridge so as to stop the squeezing-out of the viscous fluid at the same time when the discharge shaft stops rotating.
Patent Reference 1: Japanese Patent Publication No. 3382533

### Disclosure of Invention

### Problems that Invention is to Solve

The cartridge in a conventional viscous fluid application device is exchanged for a new cartridge in which viscous fluid is filled each time the viscous fluid inside an old cartridge is used up. Hence, in order to improve the manufacturing efficiency by the viscous fluid application device, it is desirable that cartridges have a large capacity. In particular, a large amount of viscous fluid is used in the case of applying a sealing compound. Therefore, in the case of manufacturing semiconductor packages with a cover, it is desirable that cartridges have a large capacity. This is because cartridges having a small capacity must be frequently exchanged due to heavy consumption of sealant material to attach covers, and because the time required to adjust the conditions for application and to exchange results in a deterioration in the operating rate. The use of large-capacity cartridges allows reducing the cost for filling syringes and reducing unit cost of raw materials.

However, in the case of a conventional viscous fluid application device which includes an application head having the integrated supply unit and application unit, since it performs application actions by causing the application head to move in the X, Y and Z directions, the use of large-capacity cartridges results in a deterioration in position accuracy at the time of application. This is because a big inertia force works on the application head when the application head is stopped. In addition, the application head, which has a high space share, needs to move in the center part of the viscous fluid application device. This places a restriction in designing viscous fluid application devices, and thus designing flexibility decreases.

To address these problems, the present invention has an object to provide a viscous fluid application device which is capable of improving manufacturing efficiency without decreasing application position accuracy and without decreasing designing flexibility.

### Means to Solve the Problems

In order to achieve the above-described object, the viscous fluid application device of the present invention which applies viscous fluid includes: a first axis unit; a second axis unit orthogonal to the first axis unit; an application unit which is arranged so as to be movable on the first axis unit and applies the viscous fluid to an application-target object; and a supply unit which is arranged so as to be fixed on a predetermined position and separate from the application unit, and supplies the viscous fluid to the application unit. Here, the supply unit in the device may be arranged so as to be fixed on the first axis unit, and the first axis unit may be arranged so as to be movable on the second axis unit.

Since the supply unit and the application unit are not integrated with each other in this way, no big inertia works on the application unit when the application unit is stopped even in the case where the capacity of the cartridge is large. Therefore, it is possible to prevent any deterioration in application position accuracy and improve the manufacturing efficiency by the viscous fluid application device. In addition, since the supply unit does not move in the first axis, the space share of the application head is not high even in the case where the capacity of the cartridge is large. Therefore, it is possible to prevent a decrease in designing flexibility and improve the manufacturing efficiency by the viscous fluid application device. In other words, it becomes possible to realize a viscous fluid application device which is capable of improving the manufacturing efficiency of semiconductor packages without deteriorating the application position accuracy and decreasing the designing flexibility.

In addition, the supply unit in the device may include: a storage unit which stores the viscous fluid; and a supply pipe through which the viscous fluid in the storage unit is led to the application unit. Additionally, the supply pipe in the device may have a U-shaped curved part. The curved part of the supply pipe may have an attached fixing member for fixing the curved part of the supply pipe so as to maintain a constant curvature.

With this structure, the internal capacity of the supply pipe does not change and a change in pressure added to the viscous fluid resulting from a change in the internal capacity can be prevented even in the case where the relative positions of the application unit and the supply unit change. Therefore, it becomes possible to realize a viscous fluid application device which is capable of controlling the application amount of viscous fluid with a high accuracy irrespective of the positional relationship between the supply unit and the application unit.

In addition, pressure may be always added to the viscous fluid stored in the storage unit. The supply pipe may have a cock which, by opening and closing, leads or blocks the viscous fluid stored in the storage unit to the application unit.

With this structure, it becomes possible to maintain a time from when the cock is opened to when the pressure added to the viscous fluid in the storage unit starts to be added to the viscous fluid in the application unit irrespective of the distance between the supply unit and the application unit. Therefore, it becomes possible to realize a viscous fluid application device which is capable of controlling the application amount of viscous fluid with a high accuracy irrespective of the distance between the supply unit and the application unit.

In addition, the cock has an internal movable unit which is arranged so as to be reciprocable and a carry path which constitutes the internal surfaces of the movable unit. The viscous fluid application device may further include a control unit which controls to supply viscous fluid from the supply unit to the application unit by causing the movable unit to reciprocate.

With this structure, a reciprocation of an air cylinder can be directly used to open and close the cock so as to eliminate a time lag in power communication. Therefore, it is possible to control to open and close the cock with a high time accuracy, which makes it possible to realize a viscous fluid application device which is capable of controlling the application amount of viscous fluid with a high accuracy.

In addition, the application unit may be provided with a rotating member, and the rotating member may be provided, on an end, a rotatable screw for discharging viscous fluid in the application unit.

This structure enables to maintain the discharge amount of viscous fluid, although the discharge amount changes depending on the amount of the viscous fluid in the application unit in the case where the viscous fluid is discharged by using atmospheric pressure. Therefore, it becomes possible to realize a viscous fluid application device which is capable of controlling the application amount of viscous fluid with a high accuracy.

In addition, the rotating member may stop rotating when a predetermined time passed after the cock is closed. A time secured between when the cock is closed and when the rotating member stop rotating may be set longer than the time from when the cock is closed to when a residual pressure on the viscous fluid which is present in the application unit side divided by the cock disappears.

This makes it possible to prevent the viscous fluid from being discharged due to a residual pressure after the application action is completed. Therefore, it becomes possible to realize a viscous fluid application device which is capable of controlling the application amount of viscous fluid with a high accuracy even in the case where the distance between the supply unit having a cartridge and the application unit increases.

In addition, the rotating member may start to rotate when a predetermined time passed after the cock is opened. A time secured between when the cock is opened and when the rotating member starts rotating may be set longer than the time from when the cock is opened to when the pressure added to the viscous fluid which is present in the supply unit side divided by the cock starts to be added to the viscous fluid which is present in the application unit side.

By doing so, the application unit starts an application action after being surely supplied with viscous fluid. This prevents that the viscous fluid contains air bubbles and is discharged after the completion of the application action. Therefore, it becomes possible to realize a viscous fluid application device which is capable of controlling the application amount of viscous fluid with a high accuracy even in the case where the distance between the supply unit having a cartridge and the supply unit increases.

In addition, the cock may be arranged in the supply pipe near the application unit.
By doing so, it becomes possible to shorten the time required until pressure added to the viscous fluid in the cartridge starts to be added to the viscous fluid in the application unit after the cock is opened and to shorten a time lag from when the cock is opened to when an application action is started. Therefore, it becomes possible to realize a viscous fluid application device which is capable of controlling the application amount of viscous fluid with a high accuracy without reducing the manufacturing efficiency even in the case where the distance between the supply unit having a cartridge and the application unit increases.

In addition, the supply unit in the device may include: a tube-shaped tank which stores viscous fluid; a piston which covers the surface of the viscous fluid stored in the tank and moves up and down in the tank; and an air supply unit which supplies air to a space above the piston in the tank. The air supply unit in the device may change the pressure of the air which is being supplied in the case where a time during which an application action is not performed exceeds a predetermined time. Here, at least one of the tank and the piston may be a flexible member, and the supply unit may further include a pipe which supplies the viscous fluid supplied from the tank to the application head and a cock which turns on or off a supply of the viscous fluid in the middle of the pipe.

With this structure, a motion is added to the viscous fluid in the tank even when the application head is not performing an application action, which makes it possible to prevent an increase in viscosity of the viscous fluid in the tank. Additionally, the supply unit in the present invention has a simple structure. Thus, it is possible to realize a viscous fluid application device having a simply-structured supply unit which is capable of controlling the application amount of viscous fluid with a high accuracy.

In addition, the air supply unit in the device may repeat increasing and decreasing the pressure of the air which is being supplied in the case where a time during which the application action is not performed exceeds a predetermined time. In the case where the time during which the application action is not performed exceeds a predetermined time, the air supply unit in the device may repeat the following alternately: supplying an air pressure greater than the atmosphere pressure to the space; and releasing the supplied air to the atmosphere.

In this way, a simple repetition of supplying and not supplying air to the tank is suffice to prevent an increase in viscosity of the viscous fluid. Therefore, it becomes possible to realize a viscous fluid application device having a further simply-structured supply unit.

In addition, the piston in the device may be a tube having a side wall which is in contact with the internal wall of the tank, and scrapes down viscous fluid attached to an internal surface of the tank while the piston moves up and down.

With this structure, the piston scraps down viscous fluid attached to the internal wall of the tank. Therefore, it becomes possible to realize a viscous fluid supply device which has a supply unit for surely supplying the viscous fluid in the tank to the application head.

In addition, the present invention can be a viscous fluid application method in the viscous fluid application device. The method for the viscous fluid application device may include: a supply completing step of completing a supply action of the supply unit; and an application completing step of completing an application action of the application unit when a predetermined time passed after the supply action is completed. Here, the supply unit in the device may include: a supply pipe through which viscous fluid is led to the application unit; a storage unit which stores the viscous fluid and adds pressure to the stored viscous fluid so that the viscous fluid is squeezed out to the supply pipe; and a cock connected to the supply pipe. The supply action may be completed by closing the cock in the supply completing step. The time secured between when the supply action is completed and when the application action is completed may be longer than the time from when the cock is closed to when a residual pressure added to the viscous fluid in the supply pipe between the application unit and the cock and to the viscous fluid in the application unit disappears. Further, the supply unit may include a supply pipe which supplies viscous fluid to the application unit, and a storage unit which stores the viscous fluid. In the supply completing step, the supply action may be completed by stopping adding pressure to the viscous fluid in the storage unit. The time secured between when the supply action is completed and when the application action is completed may be longer than the time from when the pressure added to the viscous fluid in the storage unit is stopped to when a residual pressure added to the viscous fluid in the supply pipe and the application unit disappears.

By doing so, it becomes possible to prevent the viscous fluid from being discharged due to a residual pressure after the completion of the application action. Therefore, it becomes possible to realize a viscous fluid application method which allows controlling the application amount of the viscous fluid with a high accuracy even in the case where the distance between a cartridge of the supply unit and the application unit increases.

In addition, the present invention can be a viscous fluid application method in the viscous fluid application device. The method, for the viscous fluid application device may include: a supply starting step of starting a supply action of the supply unit; and an application starting step of starting an application action of the application unit when a predetermined time passed after the supply action is started. Here, the supply unit in the device may include: a supply pipe through which viscous fluid is led to the application unit; a storage unit which stores the viscous fluid and adds pressure to the stored viscous fluid so that the viscous fluid is squeezed out to the supply pipe; and a cock connected to the supply pipe. In the device, the supply action is started by opening the cock in the supply starting step, and a time secured between when the supply action is started and when the application action is started is longer than a time required between when the cock is opened and when a pressure added to the viscous fluid in the supply pipe between the storage unit and the cock starts to be added to the viscous fluid in the application unit. Further, the supply unit may include a supply pipe which supplies viscous fluid to the application unit, and a storage unit which stores the viscous fluid. In the supply starting step, the supply action may be started by starting to add pressure to the viscous fluid in the storage unit so as to squeeze out the viscous fluid to the supply pipe. The time secured between when the supply action is started and when the application action is started may be longer than the time
from when pressure starts to be added to the viscous fluid in the storage unit to when the pressure added to the viscous fluid in the storage unit starts to be added to the viscous fluid in the application unit.

By doing so, the application unit starts an application action after being surely supplied with viscous fluid. This prevents that the viscous fluid contains air bubbles and is discharged after the completion of the application action. Therefore, it becomes possible to realize a viscous fluid application device which is capable of controlling the application amount of viscous fluid with a high accuracy even in the case where the distance between a cartridge of the supply unit and the supply unit increases.

Here, the application unit may have an internal screw-shaped rotating member which is arranged so as to be rotatable, and which rotates so as to discharge the viscous fluid in the application unit. In the application completing step, the application action may be completed by stopping the rotation of the rotating member. The application unit may have an internal screw-shaped rotating member which is arranged so as to be rotatable, and which rotates so as to discharge the viscous fluid in the application unit. In the application starting step, the application action may be started by rotating the rotating member.

This structure enables to maintain the discharge amount of viscous fluid, although the discharge amount changes depending on the amount of the viscous fluid in the application unit in the case where the viscous fluid is discharged by using atmospheric pressure. Therefore, it becomes possible to realize a viscous fluid application device which is capable of controlling the application amount of viscous fluid with a high accuracy.

In addition, the cock may be connected in the supply pipe near the application unit.
By doing so, it becomes possible to shorten the time required until pressure added to the viscous fluid in the storage unit; that is, the cartridge, starts to be added to the viscous fluid in the application unit after the cock is opened and to shorten a time lag from when the cock is opened to when an application action is started. Therefore, it becomes possible to realize a viscous fluid application device which is capable of controlling the application amount of viscous fluid with a high accuracy without reducing the manufacturing efficiency by the viscous fluid application device even in the case where the distance between the cartridge and the application unit increases.

In addition, the cock may have an internal movable unit which is arranged so as to be reciprocable and a carry path which constitutes the internal surfaces of the movable unit. The cock may be opened and closed by reciprocating the movable unit.

With this structure, a reciprocation of an air cylinder can be directly used to open and close the cock so as to eliminate a time lag in power communication. Therefore, it is possible to control to open and close the cock with a high accuracy, which makes it possible to realize a viscous fluid application device which is capable of controlling the application amount of viscous fluid with a high accu racy.

### Effects of the Invention

With the present invention, it becomes possible to realize a viscous fluid application device which is capable of improving manufacturing efficiency without deteriorating application position accuracy and without decreasing designing flexibility. In addition, it becomes possible to realize a viscous fluid application device which is capable of controlling the application amount of the viscous fluid with a high accuracy.

Hence, with the present invention, it becomes possible to provide a viscous fluid application device which is capable of improving manufacturing efficiency without deteriorating application position accuracy and without decreasing designing flexibility. Therefore, the present invention is highly applicable.

In addition, with a viscous fluid application device according to the present invention, the only thing required to prevent a viscosity increase in the viscous fluid inside the tank is controlling a solenoid valve to turn on or off air supply to a tank, and thus there is no need to place a new member in the tank or to modify the structure of the tank. This allows realizing a viscous fluid application device having a simply-structured supply unit which enables to control the application amount of viscous fluid with a high accuracy. In other words, it becomes possible to realize a viscous fluid application device having a small and low-cost supply unit which enables to control the application amount of viscous fluid with a high accuracy.

Thus, with the present invention, it becomes possible to provide a simply-structured viscous fluid application device which is capable of controlling the application amount of viscous fluid with a high accuracy. Therefore, the present invention is highly applicable.

In addition, with a viscous fluid application method according to the present invention, it becomes possible to control the application amount of viscous fluid with a high accuracy even in the case where the distance between a cartridge and the application unit increases.

In addition, with a viscous fluid application device according to the present invention, it becomes possible to improve manufacturing efficiency by the viscous fluid application device. Additionally, it becomes possible to improve designing flexibility and application position accuracy of the viscous fluid application device.

Thus, with the present invention, it becomes possible to provide a viscous fluid application method which enables to control the application amount of viscous fluid with a high accuracy even in the case where the distance between a cartridge and the application unit increases.

### Brief Description of Drawings

FIG. 1 is a cross-sectional view showing the structure of a semiconductor package.
FIG. 2 is an external view of a conventional viscous fluid application device.
FIG. 3 is a cross-sectional view showing the structure of an application head 1000.
FIG. 4 is an external view of a viscous fluid application device of an embodiment of the present invention.
FIG. 5 is a diagram for illustrating the structure of the viscous fluid application device of the embodiment.
FIG. 6 is a cross-sectional view showing the structure of the application head 100.
FIG. 7A is perspective views of an application unit 101, a supply unit 102, and a supply pipe 340 which connects the application unit 101 and the supply unit 102. These perspective views show the status of the supply pipe 340 at the time when the application unit 101 and the supply unit 102 are placed in distant positions in the respective ends of an X unit.
FIG. 7B is perspective views of an application unit 101, a supply unit 102, and a supply pipe 340 which connects the application unit 101 and the supply unit 102. These perspective views show the status of the supply pipe 340 at the time when the application unit 101 and the supply unit 102 are placed in approximate positions in one of the ends of the X unit.
FIG. 8A is a cross-sectional view of the supply cock 341 at the time when the supply cock 341 is open.
FIG. 8B is a cross-sectional view of the supply cock 341 at the time when the supply cock 341 is closed.
FIG. 9 is a flow chart for illustrating an application action of the viscous fluid application device of the embodiment.
FIG. 10(a) is a diagram showing open and close timings of the supply cock 341; FIG. 10(b) is a diagram showing timings of rotating the discharge shaft 320; and FIG. 10(c) is a diagram showing timings of discharging viscous fluid from a nozzle 310.
FIG. 11A is a cross-sectional view of the supply cock 820 at the time when the supply cock 820 is open.
FIG. 11B is a cross-sectional view of the supply cock 820 at the time when the supply cock 820 is closed.
FIG. 12 is a conceptual rendering showing a supply cock, the driving unit of the supply cock and a control unit of the embodiment.
FIG. 13 is a flow chart showing each action of the viscous fluid application device of the embodiment.
FIG. 14(a) is a diagram showing time lags of open and close statuses and open and close timings of the supply cocks which have been set initially; FIG. 14(b) is a diagram showing the state realized by shifting the open and close timings of the supply cock based on the delay time; FIG. 14(c) is a diagram showing timings of rotating the discharge shaft; and FIG. 14(d) is a diagram showing timings of discharging viscous fluid from the nozzle.
FIG. 15(a) is a diagram showing open and close timings of the supply cocks; and FIG. 15(b) is a diagram showing timings of stopping the rotation of the discharge cock.
FIG. 16 is a diagram illustrating the structure of the application head and the viscous fluid application device.
FIG. 17 is a diagram showing a change in power added to a cartridge and a piston.
FIG. 18A is a diagram showing a relationship between time passage and viscosity of viscous fluid inside a cartridge in the case where an application action and carrying-in and carrying-out of a substrate are not performed. FIG. 18A shows the case where constant compressed air has been continuously supplied to the viscous fluid in the cartridge 330 through the piston 334 without being released, or the case where the viscous fluid has been left alone in a state where compressed air is released.
FIG. 18B is a diagram showing a relationship between time passage and viscosity of the viscous fluid inside a cartridge at the time when an application action and carrying-in and carrying-out of a substrate are not performed. FIG. 18B shows the case where constant compressed air has been continuously supplied to the viscous fluid in the cartridge 330 through the piston 334, has been released, and then has been continuously supplied again.
FIG. 19A is a diagram showing a relationship between the number of application times and the application amount after an application action is restarted.
FIG. 19B is a diagram showing a relationship between the number of application times and the application amount after an application action is restarted.

### Numerical References

- 100 and 1000: Application heads
- 101 and 1110: Application units
- 102 and 1120: Supply units
- 110 and 1020: X axis units
- 120: Y axis unit
- 130: Z axis unit
- 140: Substrate carrying unit
- 140a and 900: Substrates
- 150: Head height detection sensor
- 160 and 1030: Control units
- 310 and 1111: Nozzles
- 320 and 1112: Discharge shafts
- 321 and 1113: Screw units
- 330, 1040 and 1121: Cartridges
- 331: Turning on/off valve
- 332: Air supply source
- 334: Piston
- 340, 342, 343 and 1122: Supply pipes
- 341 and 820: Supply cocks
- 400: movable unit
- 500 and 800: Open/Close determination units
- 510 and 810: carry paths
- 800: Rotation unit
- 910: Semiconductor chip
- 920: Electrode bump
- 930: Underfill adhesive
- 940: Cover
- 950: Flux
- 960: Sealing compound
- 1010: Y table
- 1130: Connection unit
- 1200: Air cylinder
- 1210: Air valve
- 1221: Valve control unit
- 1222: Sensor signal receiving unit
- 1223: Delay time measurement unit

### Best Mode for Carrying Out the Invention

A viscous fluid application device in an embodiment of the present invention is described below with reference to the drawings.

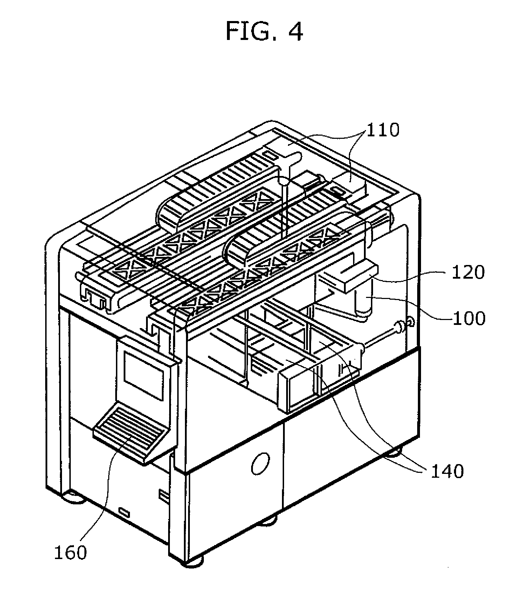

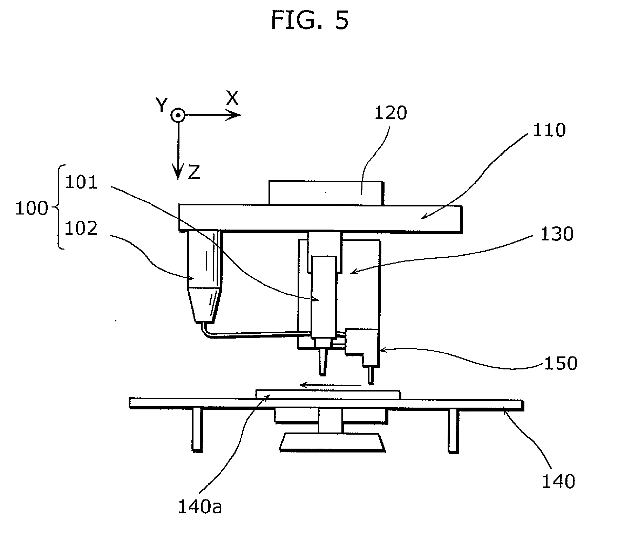

FIG. 4 is an external view of the viscous fluid application device of this embodiment. FIG. 5 is a diagram for illustrating the structure of the viscous fluid application device.

The viscous fluid application device of this embodiment includes: an application head 100 which applies viscous fluid to a substrate 140a; a first axis unit 110 (for example, the X axis) for performing positioning of the application head 100 in the first axis direction; a second axis unit 120 (for example, the Y axis) for performing positioning of the application head 100 in the second axis direction that is orthogonal to the first axis direction; a third axis unit 130 (for example, the Z axis) for performing positioning of the application head 100 in the third axis direction that is orthogonal to the plane formed by the first axis direction and the second axis direction; a substrate carrying unit 140 which carries the substrate 140a to a predetermined position on the plane formed by the first axis direction and the second axis direction; a head height detection sensor 150 which detects the height of the application head 100; and a control unit 160 which controls moving actions of the first axis unit 110, the second axis unit 120 and the third axis unit 130, and controls application actions of the application head 100.

Hereinafter, the first axis direction is referred to as X direction, the second axis direction is referred to as Y direction, and the third axis direction is referred to as Z direction, and the first axis unit is referred to as X axis unit, the second axis unit is referred to as Y axis unit, and the third axis unit is referred to as Z axis unit. However, it should be noted that the first, second and third axis units are not limited to these.

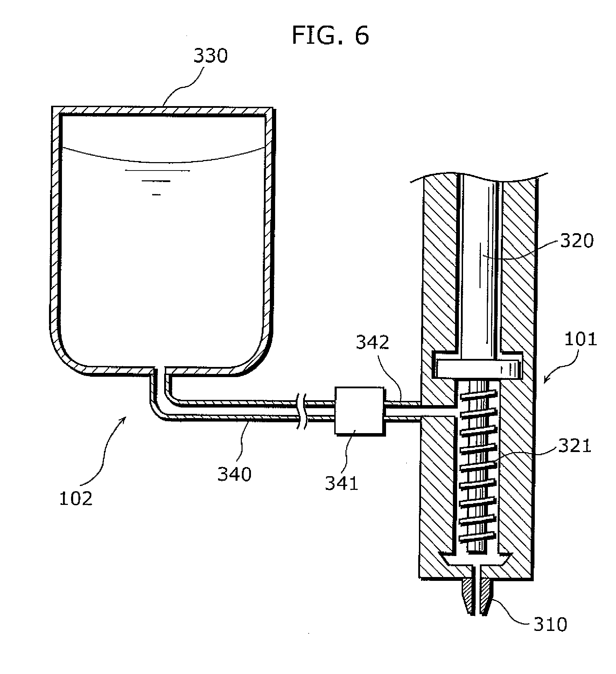

FIG. 6 is a cross-sectional view showing the structure of the application head 100.
The application head 100 includes an application unit 101 and a supply unit 102. The application unit 101 has a nozzle 310 and a discharge shaft 320 for discharging viscous fluid, is movable in the X, Y and Z directions, and applies viscous fluid to the substrate 140a. The supply unit 102 holds viscous fluid, has an exchangeable cartridge 330 and a supply pipe 340 for leading the viscous fluid in the cartridge 330 to the application unit 101 is arranged so as to be fixed on an end part of the X axis unit, is movable in the Y direction, and supplies viscous fluid to the application unit 101. As described above, the application unit and the supply unit are not integrated with each other unlike a conventional viscous fluid application device. Thus, a big inertia force does not work on the application unit 101 when the application unit 101 stops, and therefore it becomes possible to control the application position of the viscous fluid with a high accuracy. This provides a great effect in the case where a viscous fluid application device includes a supply unit 102 having a large-capacity cartridge 330 as the present invention.

In addition, when the application unit 101 attached to the X axis unit moves in the Y direction, the supply unit 102 fixed on the end of the X axis unit moves in the Y direction together with the application unit 101 in association with a movement of the X axis unit. When the application unit 101 moves in the Y and Z directions, the supply unit 102 remains stopped irrespective of a movement of the application unit 101, which enables to reduce the space share of the application head. Therefore, it becomes possible to increase a designing flexibility of the viscous fluid application device. In particular, this provides a great effect in the case where the capacity of a cartridge is large. This is because, when the cartridge moves in the X, Y and Z directions together with the application unit, the space share of the application head is high.

The discharge shaft 320 is arranged inside the application unit 101 so as to be rotatable in the axis direction along the axis of the nozzle 310. The discharge shaft 320 has an end in which a screw unit 321 is formed, and viscous fluid is led from the supply unit 102 to a space inside the part in which the screw unit 321 is formed. The screw unit 321 carries the viscous fluid according to a rotation of the discharge shaft 320, and discharges the viscous fluid through the nozzle 310. When the viscous fluid is to be discharged through the nozzle 310, pressure generated by a rotation of the screw is utilized. This eliminates the necessity to consider a difference in air pressure put on viscous fluid depending on the remaining amount of the viscous fluid inside the application unit 101, unlike in the case of causing viscous fluid to be discharged by air pressure. Therefore, it becomes possible to control the application amount of viscous fluid with a high accuracy.

The cartridge 330 is arranged in an end part of the X axis unit so as to be movable in the Y direction. The cartridge 330 has a large capacity (for example 600 cc) compared to a conventional small-capacity cartridge (for example 180 cc). This enables to reduce the number of times of exchanging cartridges, and thus it becomes possible to improve a manufacturing efficiency by the viscous fluid application device. In particular, since a large amount of sealing compound must be applied in the case of manufacturing semiconductor packages with a cover as shown in FIG. 1, this provides a great effect in the case of manufacturing such semiconductor packages.

To the viscous fluid inside the cartridge 330 pressure such as air pressure is always added, and the pressure squeezes out the viscous fluid to the supply pipe 340. A supply cock 341 is connected to the supply pipe 340 on the part near the application unit 101. Whether the supply cock 341 is open or closed determines whether or not the viscous fluid inside the cartridge 330 is led to the application unit 101. The pressure added to the viscous fluid inside the cartridge 330 is also always added to the viscous fluid inside the supply pipe 343 positioned on the supply unit side divided by the supply cock 341. The device is configured so that the supply cock 341 is present at the supply pipe 340 on the part near the application unit 101. This makes it possible to reduce the time required until the pressure starts to be added to the viscous fluid inside the application unit. In particular, in the case where the distance between the supply unit 102 having the cartridge 330 and the application unit 101 is great, the time required until the pressure added to the viscous fluid inside the cartridge 330 starts to be added to the viscous fluid inside the application unit 101. Thus, the present invention provides a great effect in the case where the distance between the supply unit 102 having the cartridge 330 and the application unit 101 is great. In addition, the present invention enables to maintain the time from when the supply cock 341 is opened to when the pressure added to the viscous fluid inside the cartridge 330 starts to be added to the viscous fluid inside the application unit 101 irrespective of whether the distance between the supply unit 102 and the application unit 101 is great or not. Therefore, it becomes possible to control the application amount of viscous fluid with a high accuracy irrespective of whether the distance between the supply unit 102 and the application unit 101 is great or not.

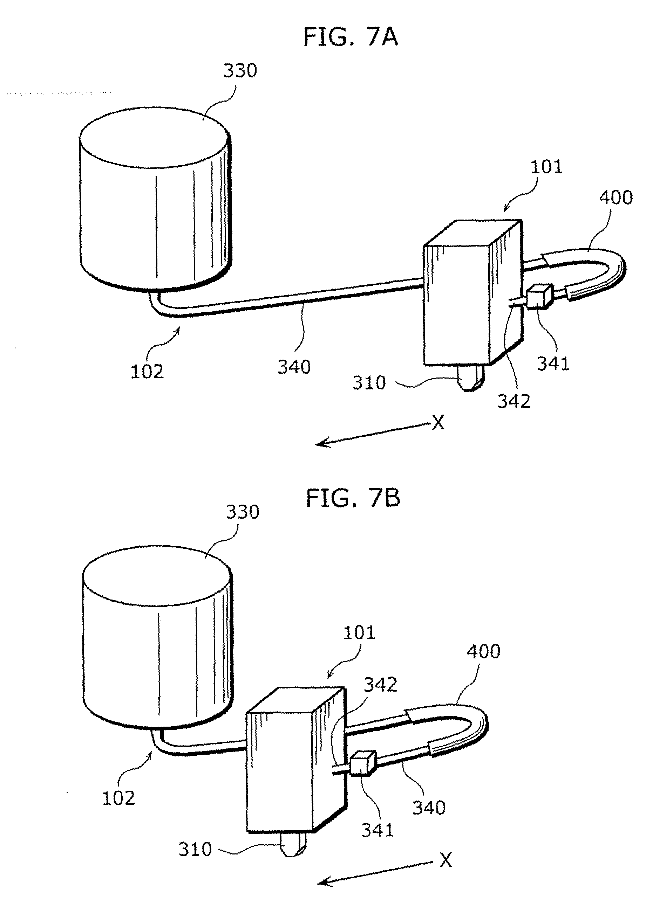

FIG. 7A and 7B each shows positions of the application unit 101 and the supply unit 102, and the state of the supply pipe 340 connected to these. FIG. 7A and 7B are distinguished in that they illustrate different states of relative position relationships between the application unit 101 and the supply unit 102.

The supply pipe 340 has, for example, has a diameter of 8 mm and a predetermined length of 730 mm. A part of the supply pipe 340 is covered with a fixing member 400 for maintaining a predetermined shape, for example, a U-shape. With this, the application unit 101 moves in the X direction, and thus, even in the case where the relative positions of the application unit 101 and the supply unit 102 change, the supply pipe 340 is not bent resulting in adding pressure onto the inside viscous fluid. Since the internal space of the supply pipe 340 does not change, and thus it is possible to prevent a change in pressure added to the viscous fluid due to a change in the internal space. In other words, it is possible to control the application amount of the viscous fluid with a high accuracy irrespective of the position relationship between the supply unit 102 and the application unit 101. At this time, the supply pipe 342 positioned at the application unit side divided by the supply cock 341 has, for example, a length of 130 mm.

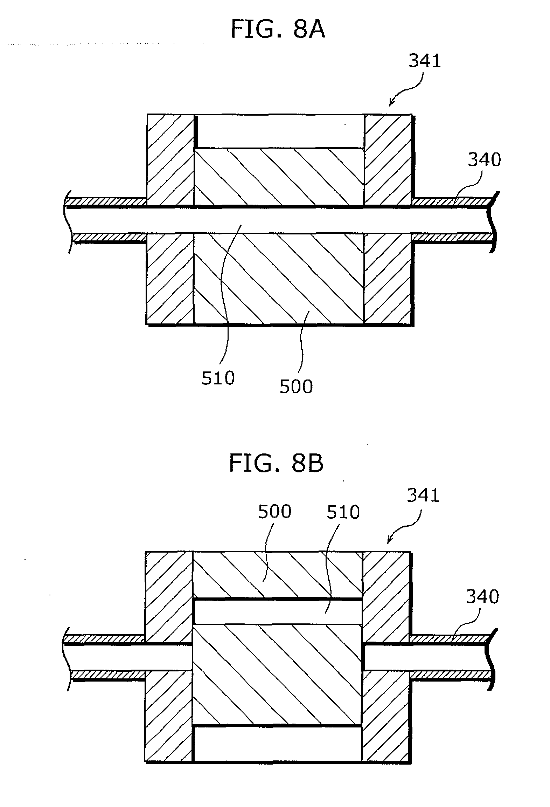

FIG. 8A and 8B are cross-sectional diagrams of the supply cock 341. FIG. 8A shows a cross-sectional diagram when the supply cock 341 is open. FIG. 8B shows a cross-sectional diagram at the time when the supply cock 341 is closed.

Inside the supply cock 341, a movable unit 500 which is arranged so as to be reciprocable, and a carry path 510 which is straight and constitutes parallel internal surfaces of the movable unit 500. Whether or not to allow viscous fluid to pass through the carry path 510 is determined depending on a reciprocation of the movable unit 500.

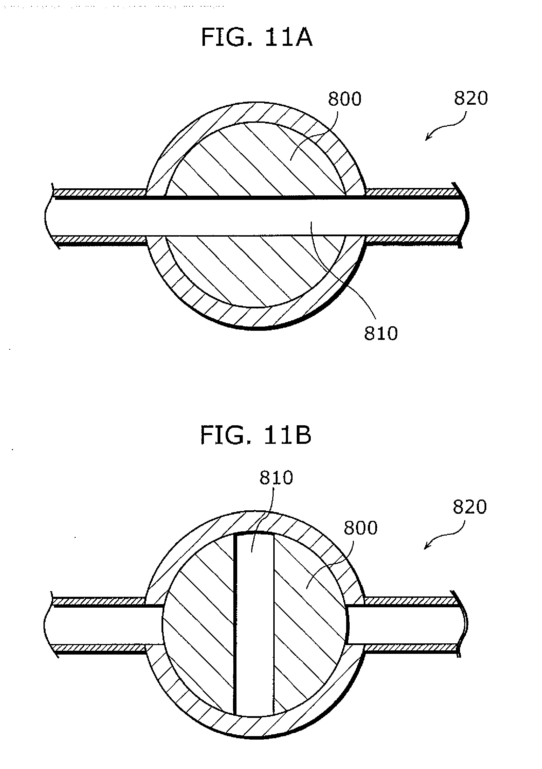

Here, the driving source of the movable unit 500 is a reciprocation of an air cylinder. This makes it possible to use the reciprocation of the air cylinder as it is for opening or closing the supply cock 341. Therefore, it is possible to eliminate a time lag in power transmission, and thus it is possible to control to open and close the supply cock 341 with a high accuracy. In addition, since viscous fluid passes through the straight carry path 510, it is possible to reduce pressure loss by the supply cock 341, and thus it is possible to prevent a change in pressure added to the viscous fluid at the supply cock 341. On the other hand, when the supply cock 820 structured as shown in FIG. 11A and 11B is opened or closed, a rotation unit 800 is rotated through a linkage driven by a reciprocation of the air cylinder. Thus, a time lag in power transmission occurs. Note that it is possible to directly rotate the rotation unit 800 by using a motor as a driving source, but this requires high cost.

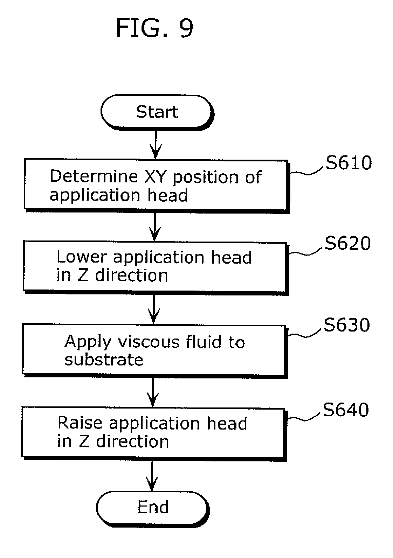

FIG. 9 is a flow chart for illustrating an action of the viscous fluid application device having the above-mentioned structure.

First, the application head 100 is moved to a predetermined X-Y position by using the X axis unit 110 and the Y axis unit 120 (Step S610). This is performed by causing the Y axis unit 120 to move the application unit 101 and the supply unit 102 to a predetermined Y position, and by causing the X axis unit 110 to move the application unit 101 to a predetermined X position.

Next, the Z axis unit 130 lowers the application head 100 down to a predetermined height (Step S620).

Next, the application head 100 applies viscous fluid to the substrate 140a (Step S630). Note that an application action is described in detail later.

Lastly, the Z axis unit 130 raises the application head 100 up to a predetermined height (Step S640).

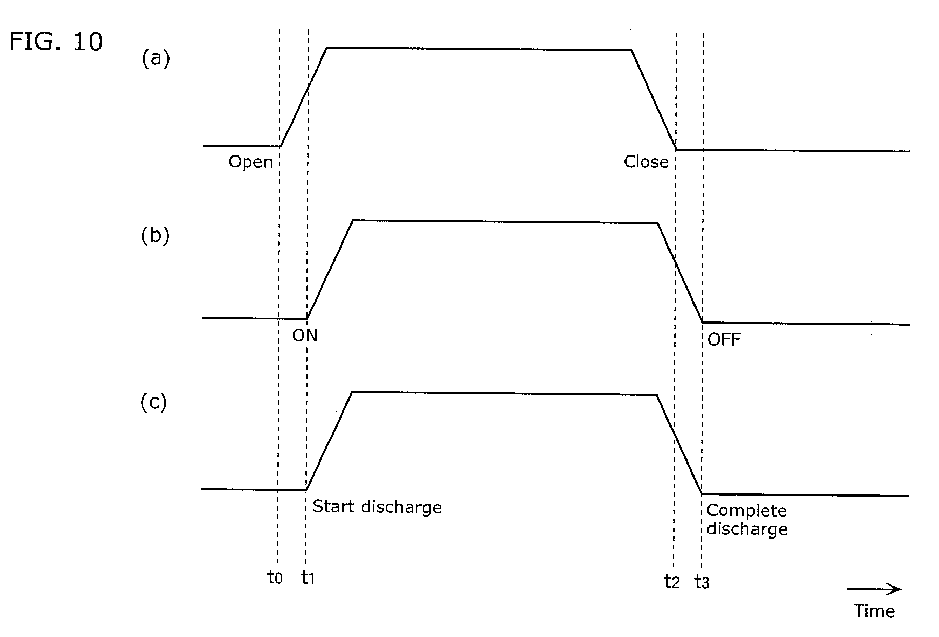

FIG. 10 is a timing chart for illustrating an application action (application action in Step S630 of FIG. 9) by the application head 100. Note that FIG. 10(a) shows open and close timings of the supply cock 341. FIG. 10(b) shows timings of rotating the discharge shaft 320. FIG. 10(c) shows timing of discharging viscous fluid from the nozzle 310.

First, the supply unit 102 is caused to start an action of supplying viscous fluid (t=to). In other words, the supply cock 341 is opened to supply viscous fluid to the application unit 101.

Next, the application unit 101 is caused to start an action of applying the viscous fluid (t=t₁). In other words, the screw unit 321 is rotated to discharge the viscous fluid from the nozzle 310.

Next, the supply unit 102 is caused to complete an action of supplying viscous fluid (t=t₂). In other words, the supply cock 341 is closed to stop supplying viscous fluid to the application unit 101.

Lastly, the application unit 101 is caused to complete an action of applying the viscous fluid (t=t₃). In other words, the screw unit 321 is caused to stop rotating so as to stop discharging the viscous fluid from the nozzle 310.

Here, the supply pipe 340 is divided into a supply unit side and an application unit side by the supply cock 341, and viscous fluid present in the supply unit side of the supply pipe 343 is always subjected to pressure. When the supply cock 341 is opened in this state, the pressure added to the viscous fluid of the supply unit side of the supply pipe 343 starts to be added to the viscous fluid of the application side of the supply pipe 342. The time t₁-t₀ from when the supply cock 341 is opened to when the discharge shaft 320 starts to rotate is set to be longer than the time from when this supply cock 341 is opened to when the time pressure starts to be added to the viscous fluid of the application unit side of the supply pipe 342. The minimum time t₁-t₀ varies mainly depending on the length and the internal space of the application unit side of the supply pipe 342.

Pressure added to the viscous fluid present in the application unit side of the supply pipe 342 while the application is being executed exists as residual pressure even after the supply cock 341 is closed to cause the discharge shaft 320 to stop rotating. The time t₃-t₂ from when this supply cock 341 is closed to when the discharge shaft 320 stop rotating is set to be longer than the time from when this supply cock is closed to when the residual pressure being added to the viscous fluid of the application unit side of the supply pipe 342 disappears. The minimum time t₃-t₂ varies mainly depending on the length and internal space of the application unit side of the supply pipe 342.

In the case where the internal space of the application unit side, divided by the supply cock 341, of the supply pipe 342 is, for example, 24.5 cc, and the space inside the part in which the screw unit 321 of the application unit 101 is formed is, for example, 0.01 cc, the minimum time t₁-t₀ and the time t₃-t₂ are approximately 0.2 sec.

As described above, with the viscous fluid application device of this embodiment, at the time when the supply cock 341 is opened, the discharge shaft 320 starts to rotate after viscous fluid is surely supplied to the application unit 101, and at the time when the supply cock 341 is closed, the discharge shaft 320 stops rotating at the time when the residual pressure to the viscous fluid inside the supply pipe 342 positioned at the application unit side and the viscous fluid inside the application unit 101 surely disappears. In other words, setting the rotation stoppage timing of the discharge shaft 320 to be later than the close timing of the supply cock 341 in order to include, as a part of a normal application action, the time period during which the discharge shaft 320 is rotated until the residual pressure disappears makes it possible to prevent the viscous fluid from being discharged due to the residual pressure after the discharge shaft stops rotating.

The viscous fluid application device of the present invention has been described above based on this embodiment. However, the present invention is not limited to this embodiment, and many variations and modifications are possible without departing from the scope of the present invention.

As an example, supply of viscous fluid to the application unit 101 is controlled by closing or opening the supply cock 341 in the embodiment. However, supply of viscous fluid may be controlled based on whether or not pressure is added to the viscous fluid inside the cartridge 330 without the supply cock. In this case, the time required from when pressure starts to be added to the viscous fluid inside the cartridge to when the discharge shaft is caused to rotate is set to be longer than the time from when pressure starts to be added to the viscous fluid inside the cartridge to when the pressure added to the viscous fluid inside the cartridge is start to be added to the viscous fluid inside the application unit. In addition, the time required from when pressure to the viscous fluid inside the cartridge is stopped to when the discharge shaft is caused to stop rotating is set to be longer than the time from when pressure to the viscous fluid inside the cartridge is stopped to when the residual pressure to the viscous fluid inside the supply pipe and the application unit disappears. In other words, setting the rotation stoppage timing of the discharge shaft 320 to be later than the close timing of the supply cock 341 in order to include, as a part of a normal application action, the time period during which the discharge shaft 320 is rotated until the residual pressure disappears makes it possible to prevent the viscous fluid from being discharged due to the residual pressure after the discharge shaft stops rotating.

In addition, as a supply cock, the supply cock 820 of rotation type shown in FIG. 11A and 11B may be used. More specifically, the supply cock 820 is arranged so as to be rotatable inside the supply cock 820, and may be used for determining whether or not viscous fluid should be passed through depending on a rotation of the rotation unit 800 in which a straight carry path is formed.

In addition, the supply unit 102 is arranged so as to be fixed on an end part of the X axis unit in the embodiment. However, arrangements of the supply unit 102 are not limited to this as long as the supply unit 102 is arranged so as to be fixed and separate from the application unit 101. For example, the supply unit 102 may be arranged so as to be fixed on the end part of the viscous fluid application device separately from the X axis part and the Y axis part. In this case, in the viscous fluid application device, a space for securing a movement of the supply pipe 342 together with a movement of the application unit 101 is prepared.

In the viscous fluid application device of the embodiment, a little viscous fluid enters a gap between the body of the supply cock 341 and the movable unit 500, therefore open and close responses of the supply cock 341 deteriorates over time. Thus, a viscous fluid application device which prevents a deterioration in these open and close responses is described below with reference to the drawings. Note that the same components as the above embodiment are provided with the same reference numerals, and a description of these is omitted.

Next, another embodiment of the present invention is described with reference to the drawings. Note that the same components as the above embodiment are provided with the same reference numerals, and a description of these is omitted.

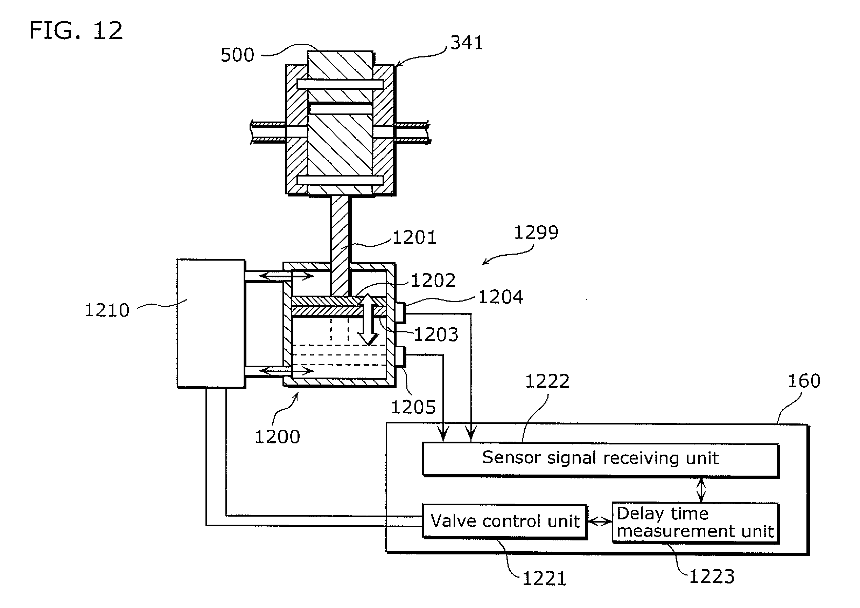

FIG. 12 is a conceptual diagram showing a supply cock 341, the driving unit 1299 of the supply cock 341 and a control unit 160.

As shown in the figure, the driving unit 1299 which opens and closes the supply cock 341 includes an air cylinder 1200 and an air valve 1210.

The air cylinder 1200 includes a piston 1202 which reciprocates inside, and a plunger 1201 connected to the piston 1202. The plunger 1201 is connected to a movable unit 500 of the supply cock 341, and the supply cock 341 can be opened and closed due to a reciprocation of the piston 1202 connected to the plunger 1201.

In addition, the piston 1201 is provided with a magnet 1203, and as status detection sensors which respond when the magnet 1203 nears, magnet sensors 1204 and 1205 are attached to two points on the external wall of the air cylinder 1200.

This magnet sensor 1204 can transmit a signal indicating a close state when the supply cock 341 is closed. On the other hand, the magnet sensor 1205 is a sensor which can transmit a signal indicating an open state when the supply cock 341 is open.

The air valve 1210 is a valve which can switch paths for compressed air by solenoid. The air valve 1210 is connected to the air cylinder 1200, and can freely cause the plunger 1201 to appear and disappear by switching the paths for the compressed air. Accordingly, the air valve 1210 can control to open and close the supply cock 341 by causing the air valve 1210 to switch the paths for the compressed air.

The control unit 160 includes a valve control unit 1221, a sensor signal receiving unit 1222, and a delay time measurement unit 1223.

The valve control unit 1221 is a processing unit for controlling the air valve 1210 to change the paths for compressed air, and in other words, a processing unit for controlling to open and close the supply cock 341.

The sensor signal receiving unit 1222 is a processing unit for receiving signals from the magnet sensors 1204 and 1205 provided with the air cylinder 1200 and grasps the state of the supply cock 341.

The delay time measurement unit 1223 is a processing unit for measuring a time lag between a signal transmitted from the valve control unit 1221 and signals to be received from the magnet sensors 1204 and 1205.

Next, a method for controlling a supply starting step by using the magnet sensors 1204 and 1205 and the like is described.

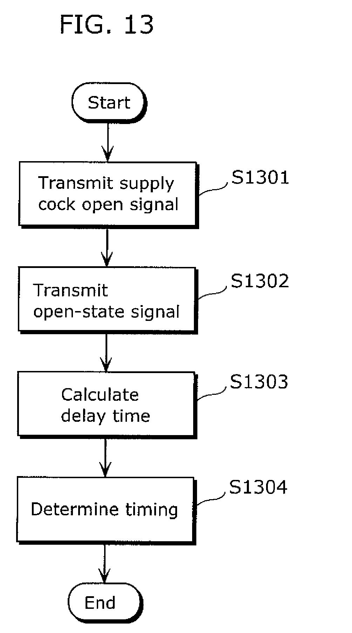

FIG. 13 is a flow chart showing each of actions of the viscous fluid application device of the present invention.

First, the valve control unit 1221 transmits a cock open signal for opening the supply cock 341 to the air valve 1210 (S1301).

Based on this open signal, the air valve 1210 changes paths for compressed air to the direction in which the plunger 1201 of the air cylinder 1200 is immersed. This moves the movable unit 500 of the supply cock 341, resulting in opening the supply cock 341.

When the supply cock 341 is opened, the magnet sensor 1205 transmits an open state signal indicating that the supply cock 341 is opened (S1302), and the sensor signal receiving unit 1222 receives this signal.

The delay time measurement unit 1223 measures the time from when the valve control unit 1221 transmits the open signal to when the sensor signal receiving unit 1222 receives the open state signal, and calculates the delay time (S1303).

The control unit 160 determines the timing at which the discharge shaft 1112 starts to rotate (t₁ in FIG. 10) based on the time when the supply starts; that is, the time when the cock open signal is transmitted (t₀ in FIG. 10)(S1304).

An application action is performed by using the determined timings from next time.

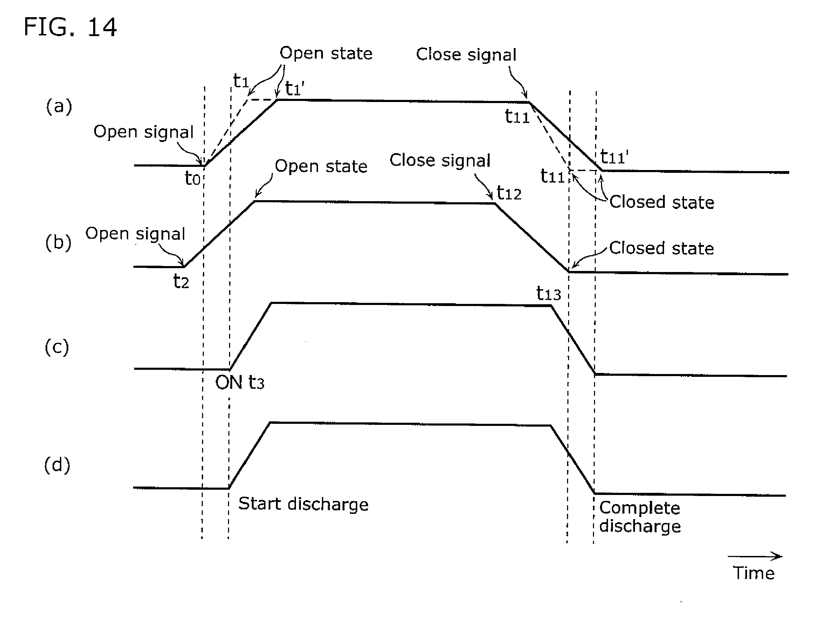

FIG. 14 is a timing chart for illustrating the application action by the application head 100 of this embodiment. FIG. 14(a) shows a time lag (delay time) between the open and close timings and between the open and close states, of the supply cock 341, which have been set initially. FIG. 14(b) shows the state where the open and close timings of the supply cock 341 are shifted based on the delay time. FIG. 14(c) shows a rotation timing of the discharge shaft 320. FIG. 14(d) shows a timing of discharging the viscous fluid from the nozzle 310.

First, the supply unit 102 starts an supply action of the viscous fluid according to the timing to be calculated based on the internal capacities of the supply pipe 342 and the supply unit 101; that is, transmits an open signal (t=t₀) to the air valve 1210.

However, a delay occurs between an assumed open action (shown by a broken line in FIG. 14(a))of the supply cock 341 and an actual open action (shown by a solid line in FIG. 14(a)) of the supply cock 341 due to individual differences and changes over time. For example, with respect to the time t₁ when the supply cock 341 is assumed to be opened, the supply cock 341 is actually opened at time t₁'.

If this state continues, the discharge shaft 320 starts to rotate and discharge viscous fluid before the pressure inside the supply pipe 342 and the application unit 101 amounts to be sufficient. Therefore, the discharge amount of the viscous fluid at the time when the discharge starts may be insufficient.

Hence, the magnet sensors 1204 and 1205 are caused to measure the delay time, and based on this data, the timing t₂ (FIG. 14(b)) of an open signal which can absorb the individual differences and changes over time of the supply cock 341. This timing t₂ of the open signal can be inversely calculated from the timing t₃ at which the discharge shaft 320 starts to rotate.

Grasping the delay time between the transmission of the cock open signal and the reception of the open state signal in this way makes it possible to absorb the individual difference in response time of the supply cock 341 when the supply cocks 341 are exchanged or the like, and start to discharge the viscous fluid under an always stable pressure. Therefore, it becomes possible to prevent an excessive application or an insufficient application at the time when the discharge is started.

In addition, the supply cock 341 tends to become slow in response time by being used over time due to adhesion of viscous fluid to a sliding part. However, periodically measuring the delay time makes it possible to stably discharge the viscous fluid over time.

The above method is especially effective in the case where the discharge shaft 1112 starts to rotate before the supply cock 341 is opened.

On the other hand, a similar delay occurs also at the ending time of the discharge. Since the discharge shaft 320 stops while unnecessary pressure remains inside the supply pipe 342 and the application unit 101, viscous fluid may be discharged at an unexpected position at the ending time of the discharge.

The viscous fluid application device of this embodiment can determine a timing of transmitting a cock close signal by measuring a delay time at the ending time of a discharge similarly to the above.

More specifically, the viscous fluid application device can measure the delay time (t₁₁-t₁₁' in FIG. 14(a)) from when a cock close signal is transmitted to when a closed state signal is received, and determine the timing of the cock close signal (t₁₂) based on a rotation stoppage (t₁₃) of the discharge shaft 1112 derived from the delay time.

In this way, it becomes possible to complete discharging under an always stable pressure even when a response time of the supply cock 341 varies due to exchange of the supply cocks 341 performed immediately before or change over time. Therefore, it becomes possible to prevent viscous fluid from dropping or the like.

Next, another embodiment of the present invention is described with reference to the drawings. Note that the structure of the device of this embodiment is the same as those of the above embodiments, and thus a description of these is omitted.

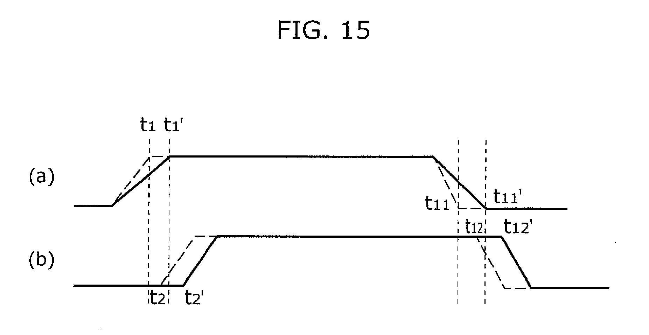

FIG. 15 is a timing chart for illustrating open and close timings of the supply cock 341 (FIG. 15(a)) and timings of stopping the rotation of the discharge shaft 320 (FIG. 15(b)).

In the case of this embodiment, as shown in FIG. 15(a) and 15(b), the rotation timing stoppage timing of the discharge shaft 320 occurs after the supply cock 341 is opened and then closed. Accordingly, it is only that the discharge shaft 320 starts to rotate after a predetermined time passed from when the supply cock 341 is opened; that is, when a signal from the magnet sensor 1205 is received. Therefore, even in the case where the open timing of the supply cock 341 delays from t₁ to t₁' due to an exchange or a change over time, it is possible to change the rotation start timing of the discharge shaft 320 from t₂ to t₂' in response to the delay.

On the other hand, when the discharge of the viscous fluid is completed, even in the case where the timing of receiving close state signal from the magnet sensor 1204 delays from t₁₁ to t₁₁', it is possible to easily shift the rotation stoppage timing of the discharge shaft 320 from t₁₂ to t₁₂'.

In this way, it is possible to control the discharge shaft 320 after grasping the state of the supply cock 341, and thus it becomes possible to respond in real time to the state of the supply cock 341.

In the viscous fluid application device of this embodiment, a supply unit 102 is arranged so as to be fixed, and thus inside viscous fluid is easy to solidify. Hence, a viscous fluid application device which prevents the viscous fluid from solidifying is described below with reference to the drawings. Note that the same components as those of the above embodiments are provided with the same reference numerals, and a description of these is omitted.

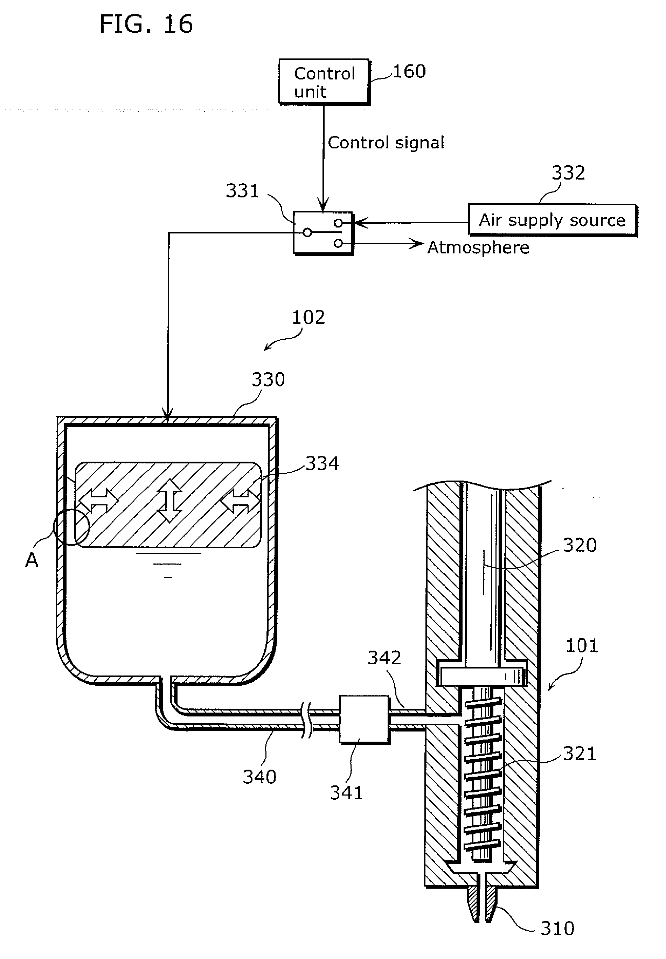

FIG. 16 is a cross-sectional view showing the structure of an application head 110 of this embodiment.
As shown in the figure, the application head 100 includes an application unit 101 and a supply unit 102. The supply unit 102 is arranged so as to be fixed on the X axis unit, holds viscous fluid, and movable in the Y direction. The supply unit 102 includes: an exchangeable cartridge 330; a switching valve 331; an air supply source 332; and a supply pipe 340 which leads the viscous fluid in the cartridge 330 to the application unit 101. Here, the supply unit 102 constitutes the viscous fluid application device, and the switching valve 331 and the air supply source 332 constitute the air supply unit.

The cartridge 330 is a tube-shaped tank having a large capacity (for example, 600 cc), is arranged on an end part of the X axis unit, and is movable in the Y direction.

Inside the cartridge 330, a piston 334 which is a tube moving up and down in the cartridge 330 and which covers the surface of the viscous fluid in the cartridge 330 are arranged. The side wall of the piston 334 is in contact with the internal wall of the cartridge 330 and the piston 334 moves along the internal wall of the cartridge 330. Thus, the viscous fluid attached to the internal wall of the cartridge 330 is scraped down by the piston 334. Here, the piston 334 is a flexible member made of plastic or the like, and the shape of the piston 334 changes according to power to be added to the external wall because it is sandwiched by the compressed air to be supplied from the air supply source 332 and the viscous fluid. Note that this piston 334 is not always necessary to be such flexible member.

To the space above the piston 334 of the cartridge 330, compressed air having a constant pressure is supplied, and the compressed air adds pressure to be added to the supply pipe 340 to the viscous fluid inside the cartridge 330. Here, the cartridge 330 is a flexible member made of polypropylene or ethylene, and the internal capacity of the cartridge 330 changes according to the power to be added by the compressed air to the internal wall. Note that this cartridge 330 is not always necessary to be such flexible member. Further, at least one of the piston 334 and the cartridge 330 may be such flexible member, both of them may be such flexible member, and neither the piston 334 nor the cartridge 330 may be such flexible member.

The switching valve 331 is activated by a control signal from the control unit 160. The switching valve 331 connects the cartridge 330 to the air supply source 332 and supplies compressed air having a pressure greater than the atmosphere to the viscous fluid inside the cartridge 330 through the piston 334. Otherwise, the switching valve 331 connects the cartridge 330 to the atmosphere and supplies the air having a pressure equivalent to the atmosphere to the viscous fluid inside the cartridge 330. Here, the compressed air forms a supply pressure.

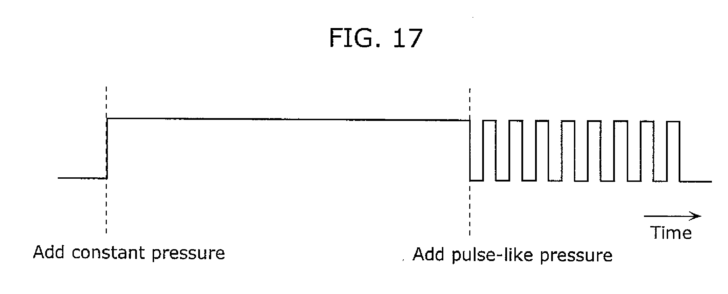

FIG. 17 is a diagram showing a change in power to be added to the viscous fluid inside the cartridge 330 through the piston 334.

FIG. 17 shows a start timing of adding a continuous and constant power to the viscous fluid inside the cartridge 330 through the piston 334 before the viscous fluid application device starts an application action, and a start timing of further adding pulse-like power to the viscous fluid inside the cartridge 330 through the piston 334, after the firstly added power is temporally released. At this time, the continuous and constant power is generated by means that the switching valve 331 connects the cartridge 330 to the air supply source 332, and that the compressed air having a pressure greater than the atmosphere is always supplied to the viscous fluid inside the cartridge 330 through the piston 334. The pulse-like power is generated by means that the switching valve 331 repeats switching at a predetermined time interval, for example, a 2-second interval, and that the discontinuous and constant compressed air which has a pressure changing at a predetermined time interval; that is, the compressed air having a pressure repeatedly increasing and decreasing is supplied to the viscous fluid inside the cartridge 330 through the piston 334.

The action of starting to add the pulse-like power is executed based on the following result detected by a substrate detection sensor. Here are examples where: an obtained result shows that a substrate which is subjected to application next cannot be carried in, within a controlled time, on the stage on which viscous fluid is applied to the substrate and a predetermined position before the application stage due to any trouble; and another obtained result shows that the substrate on which viscous fluid has been applied cannot be carried out within a controlled time due to any trouble. In these cases, after the continuous and constant compressed air supplied to the viscous fluid inside the cartridge 330 through the piston 334 is released, and subsequently the continuous and constant compressed air is supplied, which moves the piston 334 up and down so as to prevent an increase in viscosity of the viscous fluid.

However, here is a case where the time required to carry in and out the substrate is approximately equal to the time enough to increase the viscosity of the viscous fluid, and the substrate is not carried out at the time when a controlled time passed after the carry-in of the substrate is detected. In this case, even when the substrate is carried in and out within a normal time, the continuous and constant compressed air supplied to the viscous fluid inside the cartridge 330 through the piston 334 is released, and subsequently the continuous and constant compressed air is supplied, which moves the piston 334 up and down so as to prevent an increase in viscosity of the viscous fluid.

In other words, it is the case where the time during which the application head 100 does not apply viscous fluid to the substrate 140a; that is, the time during which the application head 100 does not actually perform an application action is longer, and the viscosity of the viscous fluid increases to disturb the application action. In this case, since the cartridge 330 and the piston 334 are flexible members, executing the action leads to always changing the internal space of the cartridge 330 and the shape of the piston 334, and thus a motion is always added to the viscous fluid inside the cartridge 330. This prevents an increase in the viscosity of the viscous fluid by the time when continuous and constant compressed air is supplied to the viscous fluid inside the cartridge 330 through the piston 334. In particular, the present invention provides a great effect in the case where the viscous fluid is a sealing compound. This is because the sealing compound includes a filler which is a polymeric material having a high inter-molecular attraction and the viscosity of the sealing compound is easy to increase.

For example, in the case where the viscous fluid is a sealing compound composed of silicon, the application head does not perform an application action for about 2 to 3 minutes. Since no motion is added to the viscous fluid, the viscous fluid starts to solidify due to an increase in the viscosity. However, in the case where the switching valve performs switching about 1 to 30 times per minute while the application head does not perform an application action, an increase in the viscosity of the viscous fluid is prevented, and thus solidification of the viscous fluid is prevented.

The effect of an application head of this embodiment is described below.

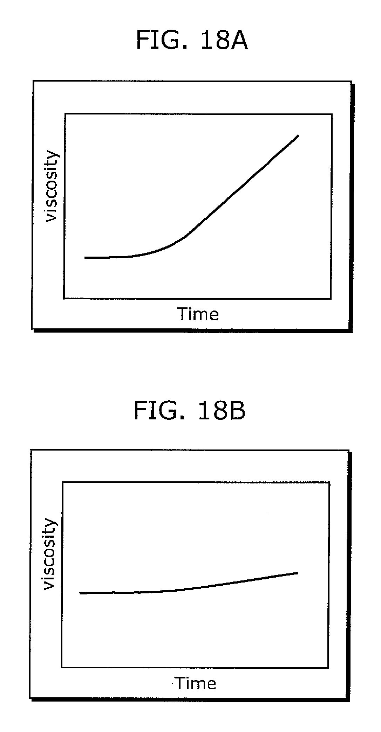

FIG. 18A shows the relationship between time passage and a change in viscosity of the viscous fluid (viscous fluid in the A part in FIG. 16) which is present in a gap between the piston 334 and the cartridge 330 under circumstances where continuous and constant compressed air has been supplied to the viscous fluid inside the cartridge 330 through the piston 334 without being released or in the case where the viscous fluid has been left alone in a state where the compressed air is released, for example, while an application action and carry-in and carry-out of a substrate are not performed. FIG. 18B is a diagram showing the relationship between time passage and a change in viscosity of the viscous fluid (viscous fluid in the A part in FIG. 16) which is present in a gap between the piston 334 and the cartridge 330 under circumstances where continuous and constant compressed air (having a pressure which changes like a pulse) which is being supplied to the viscous fluid inside the cartridge 330 through the piston 334 is temporally released, and then the compressed air is discontinuously supplied.

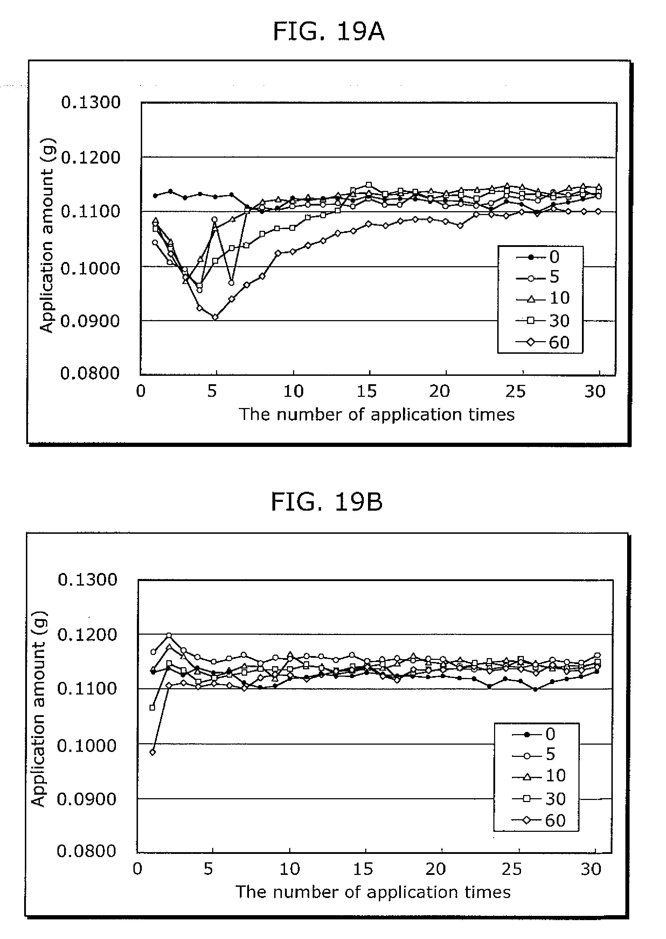

In addition, FIG. 19A and 19B each is a diagram showing the relationship between the number of application times after the application action is restarted, and the application amount at that time. Note that FIG. 18A and FIG. 19A each is a diagram showing the transition of an increase in viscosity of the viscous fluid while continuous and constant compressed air has been supplied to the viscous fluid inside the cartridge 330 through the piston 334 without being released or the viscous fluid has been left alone in a state where the compressed air is released (1) in the case where a substrate which is subjected to application next cannot be carried in, within a controlled time, on the stage on which viscous fluid is applied to the substrate and a predetermined position before the application stage due to any trouble, and in the case where the substrate on which viscous fluid has been applied cannot be carried out within a controlled time due to any trouble or other case, or (2) in the case where a substrate has been carried in and out within a normal time, but the time required to complete carry-in and carry-out is approximately equal to the time enough to increase the viscosity of the viscous fluid. On the other hand, FIG. 18B and 19B each shows the case where the continuous and constant compressed air which is being supplied to the viscous fluid inside the cartridge 330 through the piston 334 is temporally released, and subsequently the compressed air is supplied discontinuously to the viscous fluid inside the cartridge 330 under the (1) and (2) conditions. Additionally, the symbols of "●", "○", "Δ", "□" and "◇" in FIG. 19A and 19B respectively shows that the times from the times the continuous and constant compressed air which is being supplied to the viscous fluid inside the cartridge 330 through the piston 334 is released to the times the compressed air having similar conditions restarts to be supplied to the viscous fluid are 0, 5, 10, 30 and 60 minutes.

It is known from FIG. 18A and FIG. 19A that, in the case where compressed air is not discontinuously supplied to the viscous fluid between the time when continuous and constant compressed air which is being added to the viscous fluid inside the cartridge 330 through the piston 334 is released and the time when the compressed air having similar conditions restarts to be supplied to the viscous fluid inside the cartridge 330 through the piston 334, the viscosity of the viscous fluid which is present in a gap between the piston 334 and the cartridge 330 increases due to the characteristics of the viscous fluid, and thus the variation of the application amount is big. On the other hand, it is known from FIG. 18B and FIG. 19B that, in the case where compressed air is discontinuously supplied to the viscous fluid between the time when continuous and constant compressed air which is being added to the viscous fluid inside the cartridge 330 through the piston 334 is released and the time when the compressed air having similar conditions restarts to be supplied to the viscous fluid, the viscosity of the viscous fluid which is present in a gap between the piston 334 and the cartridge 330 does little increase and thus the variation of the application amount is very little. It is conceivable that this is largely ascribable to the fact that an increase in viscosity of the viscous fluid (in the A part in FIG. 16) in a gap between the piston 334 and the cartridge 330 is prevented. In other words, when the viscosity of the viscous fluid in a gap between the piston 334 and the cartridge 330 increases, the piston 334 is subjected to a big resistance while it is moving down, which changes the amount of the viscous fluid supplied to the application head.

As described above, in the viscous fluid application device of this embodiment, the supply unit 102 with a simple structure can prevent an increase in viscosity of the viscous fluid inside the cartridge 330 during the period from when continuous and constant compressed air which is being supplied to the viscous fluid inside the cartridge 330 through the piston 334 is released to when compressed air having similar conditions restarts to be supplied to the viscous fluid. More specifically, the viscous fluid application device of this embodiment prevents an increase in viscosity of the viscous fluid inside the cartridge 330 by using the piston 334 and the cartridge 330 without a screw unit and a driving motor, it can realize a simply-structured supply unit which enables to control the application amount of viscous fluid with a high accuracy.

The viscous fluid application device of the present invention has been described above based on the embodiments. However, the present invention is not limited to these embodiments, and many variations and modifications are possible without departing from the scope of the present invention.

For example, an increase in viscosity of the viscous fluid is prevented by causing the switching valve 331 to repeat switching in the supply unit 102 of this embodiment so as to discontinuously supply compressed air to the viscous fluid in the cartridge 330 through the piston 334 and change the internal space of the cartridge 330 and the shape of the piston 334. However, an increase in viscosity of the viscous fluid may be prevented by providing a pressure adjustment unit instead of the switching valve 331 so as to discontinuously supply compressed air to the viscous fluid inside the cartridge 330 through the piston 334 and change the internal space of the cartridge 330 and the shape of the piston 334 (1) in the case where a substrate which is subjected to application next cannot be carried in, within a controlled time, on the stage on which viscous fluid is applied to the substrate and a predetermined position before the application stage due to any trouble, and in the case where the substrate on which viscous fluid has been applied cannot be carried out within a controlled time due to any trouble or other case, or (2) in the case where a substrate has been carried in and out within a normal time, but the time required to complete carry-in and carry-out is approximately equal to the time enough to increase the viscosity of the viscous fluid.

In addition, in the case where a time of 10 minutes or more is required between the time when an application action is completed and the time when an application action is restarted, viscous fluid to be supplied at the initial time of a restarted application action may not be applied to the substrate 140a, and the viscous fluid at the initial time may be flushed.

A substrate is described as an example of an application-target object in this embodiment. However, the present invention is applicable to a viscous fluid application device which supplies viscous fluid to an application-target object other than a substrate.

In addition, (1) in the case where a substrate which is subjected to application next cannot be carried in, within a predetermined controlled time, on the stage on which viscous fluid is applied to the substrate and a predetermined position before the application stage due to any trouble, in the case where the substrate on which viscous fluid has been applied cannot be carried out within a predetermined controlled time due to any trouble, or (2) in the case where a substrate has been carried in and out within a normal time, but a predetermined time which is required to complete the carry-in and carry-out is approximately equal to the time enough to increase the viscosity of the viscous fluid, the predetermined times may be determined based on the types of viscous fluid to be supplied to the application head 100, supply conditions such as temperature, and the like.

In addition, in this embodiment, an action of starting addition of pulse-like power is described as being executed based on a result detected by a substrate detection sensor. However, the action of starting addition of the pulse-like power may be executed based on a result obtained by the control unit 160 performing control of starting and stopping the rotation of the screw unit 321. In other words, continuous and constant compressed air may be supplied to viscous fluid inside the cartridge 330 through the piston 334, in the case where an off signal indicating a rotation stoppage within a controlled time is not transmitted after an off signal indicating a rotation start is transmitted to the screw unit 321.

### Industrial Applicability

The present invention is applicable to a viscous fluid application device, and in particular to a viscous fluid application device used in a manufacturing process of semiconductor packages.

## Claims

1. A viscous fluid application device which applies viscous fluid, comprising:
a first axis unit;
a second axis unit orthogonal to said first axis unit;
an application unit which is arranged so as to be movable on said first axis unit and is operable to apply the viscous fluid to an application-target object; and
a supply unit which is arranged so as to be fixed on a predetermined position and separate from said application unit, and is operable to supply the viscous fluid to said application unit.

2. The viscous fluid application device according to Claim 1,
wherein said supply unit is arranged so as to be fixed on said first axis unit, and
said first axis unit is arranged so as to be movable on said second axis unit.

3. The viscous fluid application device according to Claim 2,
wherein said supply unit includes:
a storage unit operable to store the viscous fluid; and
a supply pipe through which the viscous fluid in said storage unit is led to said application unit, and
said supply pipe has a U-shaped curved part.

4. The viscous fluid application device according to Claim 3,
wherein said curved part of said supply pipe has an attached fixing member for fixing said curved part of said supply pipe so as to maintain a constant curvature.

5. The viscous fluid application device according to Claim 4,
wherein said supply pipe has a cock which, by opening and closing, leads or blocks the viscous fluid stored in said storage unit to said application unit.

6. The viscous fluid application device according to Claim 1,
wherein said supply unit includes:
a tube-shaped tank which stores the viscous fluid;
a piston which covers a surface of the viscous fluid stored in said tank and moves up and down in said tank; and
an air supply unit operable to supply air to a space above said piston in said tank, and
said air supply unit is operable to change a pressure of the air which is being supplied in the case where a time during which an action of the application is not performed exceeds a predetermined time.

7. The viscous fluid application device according to Claim 6,
wherein said air supply unit is operable to repeat increasing and decreasing the pressure of the air which is being supplied in the case where a time during which the application action is not performed exceeds a predetermined time.

8. The viscous fluid application device according to Claim 7,
wherein, in the case where the time during which the application action is not performed exceeds a predetermined time, said air supply unit is operable to repeat the following alternately: supplying an air pressure greater than an atmosphere pressure to the space; and releasing the supplied air to an atmosphere.

9. The viscous fluid application device according to Claim 8,
wherein at least one of said tank and said piston is a flexible member.

10. The viscous fluid application device according to Claim 9,
wherein said piston is a tube having a side wall which is in contact with an internal wall of said tank, and scrapes down viscous fluid attached to an internal surface of said tank while said piston moves up and down.

11. A viscous fluid application method for the viscous fluid application device of Claim 1, comprising:
a supply completing step of completing a supply action of the supply unit; and
an application completing step of completing an application action of the application unit when a predetermined time passed after the supply action is competed.

12. The viscous fluid application method according to Claim 11,
wherein the supply unit includes:
a supply pipe through which viscous fluid is led to the application unit;
a storage unit which stores the viscous fluid and is operable to add pressure to the stored viscous fluid so that the viscous fluid is squeezed out to the supply pipe; and
a cock connected to the supply pipe, and
the supply action is completed by closing the cock in said supply completing step.

13. The viscous fluid application method according to Claim 12,
wherein the application unit has an internal screw-shaped rotating member which is arranged so as to be rotatable and which rotates so as to discharge the viscous fluid of the application unit, and
the application action is completed by stopping the rotating of the rotating member.

14. The viscous fluid application method according to Claim 13,
wherein a time secured between when the supply action is completed and when the application action is completed is longer than a time required between when the cock is closed and when a residual pressure on the viscous fluid in the supply pipe between the application unit and the cock and on the viscous fluid in the application unit disappears.

15. The viscous fluid application method according to Claim 14,
wherein the cock has an internal movable unit which is arranged so as to be reciprocable, and the internal movable unit has an internal carry path for viscous fluid, and
the cock is opened and closed by reciprocating the movable unit.

16. The viscous fluid application method according to Claim 12,
wherein the viscous fluid application device includes a status detection sensor for detecting a closed status of the cock, and
the viscous fluid application method further comprises:
a delay time measurement step of measuring a delay time from when a cock close signal to close the cock is transmitted to when a closed state signal indicating the closed status of the cock is received from the status detection sensor; and
a supply completion timing adjustment step of adjusting a timing at which said supply completing step is started based on the delay time.

17. The viscous fluid application method according to Claim 12,
wherein the viscous fluid application device includes a status detection sensor for detecting a closed status of the cock, and
the application action is completed when a predetermined time passed from the closed state signal indicating the closed status of the cock is received from the status detection sensor in said application completing step.

18. A viscous fluid application method for the viscous fluid application device of Claim 1, comprising:
a supply starting step of starting a supply action of the supply unit; and
an application starting step of starting an application action of the application unit when a predetermined time passed after the supply action is started.

19. The viscous fluid application method according to Claim 18,
wherein the supply unit includes:
a supply pipe through which viscous fluid is led to the application unit;
a storage unit which stores the viscous fluid and is operable to add pressure to the stored viscous fluid so that the viscous fluid is squeezed out to the supply pipe; and
a cock connected to the supply pipe,
the supply action is started by opening the cock in said supply starting step, and
a time secured between when the supply action is started and when the application action is started is longer than a time required between when the cock is opened and when a pressure added to the viscous fluid in the supply pipe between the storage unit and the cock starts to be added to the viscous fluid in the application unit.

20. The viscous fluid application method according to Claim 19,
wherein the cock has an internal movable unit which is arranged so as to be reciprocable, and the internal movable unit has an internal carry path for viscous fluid, and
the cock is opened and closed by reciprocating the movable unit.

21. The viscous fluid application method according to Claim 19,
wherein the viscous fluid application device includes a status detection sensor for detecting an open status of the cock, and
the application action is started when a predetermined time passed from the open state signal indicating the open status of the cock is received from the status detection sensor in said application starting step.

22. A solidification prevention method for the viscous fluid application device according to Claim 1,
wherein, in the case where a time during which the application action is not performed exceeds a predetermined time, air is supplied to a space filled with air in a tank in which viscous fluid is stored, an pressure of the air being repeatedly raised and lowered.
